# EUROPÄISCHE PATENTSCHRIFT

(11) **EP 2 673 554 B1**
(45) Veröffentlichungstag und Bekanntmachung des Hinweises auf die Patenterteilung: **05.10.2016**
(21) Anmeldenummer: 12701998.2
(22) Anmeldetag: 25.01.2012
(51) Int. Cl.: F21Y 113/10, F21K 9/00, H01L 27/15, H01L 33/00

(54) **LED-BELEUCHTUNGSVORRICHTUNG MIT EINEM ERSTEN LED-CHIP UND EINEM ZWEITEN LED-CHIP UND VERFAHREN ZU DESSEN HERSTELLUNG**
LED LIGHTING DEVICE WITH A FIRST LED CHIP AND A SECOND LED CHIP, AND METHOD FOR PRODUCING SAID DEVICE
DISPOSITIF D'ÉCLAIRAGE À LED COMPRENANT UNE PREMIÈRE PUCE DE LED ET UNE DEUXIÈME PUCE DE LED ET PROCÉDÉ DE FABRICATION DUDIT DISPOSITIF D'ÉCLAIRAGE

(30) Priorität: 09.02.2011 DE 102011010752
(43) Veröffentlichungstag der Anmeldung: 18.12.2013
(73) Patentinhaber: OSRAM Opto Semiconductors GmbH, 93055 Regensburg (DE)
(72) Erfinder: BEHRINGER, Martin, Rudolf, 93049 Regensburg (DE); BAUR, Elmar, 93049 Regensburg (DE)
(74) Vertreter: Epping - Hermann - Fischer
(86) Internationale Anmeldenummer: PCT/EP2012/051156
(87) Internationale Veröffentlichungsnummer: WO 2012/107291

(56) Entgegenhaltungen:
- WO-A1-2010/122312
- US-A1- 2008 291 672

## Beschreibung

### LED-Beleuchtungsvorrichtung mit einem ersten LED-Chip und einem zweiten LED-Chip und Verfahren zu dessen Herstellung

Die vorliegende Anmeldung betrifft eine LED-Beleuchtungsvorrichtung mit einem ersten LED-Chip und einem zweiten LED-Chip, die jeweils Strahlung mit einer Abstrahlcharakteristik emittieren. Weiterhin betrifft die Anmeldung ein Verfahren zum Herstellen einer derartigen LED-Beleuchtungsvorrichtung.

Um Vorrichtungen zu erzeugen, die warmweißes Licht emittieren, werden häufig LED-Chips kombiniert, die Strahlung mit unterschiedlichem Farbort emittieren. Bei unterschiedlichen Temperaturen verhalten sich die einzelnen LED-Chips jedoch unterschiedlich. Beispielsweise nimmt die emittierte Leistung der LED-Chips unterschiedlich ab und/oder die Wellenlängen der emittierten Strahlung verschieben sich unterschiedlich. Dadurch verändert sich der Farbort der von der Vorrichtung emittierten Mischstrahlung. Beispielsweise erhält so die von der Vorrichtung emittierte, ursprünglich warmweiße Strahlung einen Blau- oder Rotstich. Insbesondere wird die von der Vorrichtung emittierte Strahlung in Richtung Blau verschoben, für den Fall, dass die Umgebungstemperatur und/oder die Betriebstemperatur steigen, wohingegen die Strahlung in Richtung Rot verschoben wird, für den Fall, dass die Umgebungstemperatur und/oder die Betriebstemperatur sinken.

Um der Änderung der Leistung einzelner LED-Chips beziehungsweise der Wellenlängenverschiebung vorzubeugen, wird häufig die Temperatur der Umgebung der Vorrichtung oder der Farbort der von der Vorrichtung emittierten Mischstrahlung gemessen und der Betriebsstrom der einzelnen LED-Chips derart geregelt, dass der Farbort der von der Vorrichtung emittierten Strahlung im Wesentlichen konstant bleibt. Beispielsweise wird bei hohen Temperaturen der Betriebsstrom eines mintfarbenen LED-Chips reduziert und der Betriebsstrom eines amberfarbenen LED-Chips erhöht.

Mittels dieser Anpassungsmethode des Farborts ist jedoch eine aufwendig Stromsteuerung oder Farbortmessung notwendig, wodurch sich die Kosten einer derartigen Vorrichtung nachteilig erhöhen.

In der Druckschrift US 2008/0291672 A1 ist eine Lichtquellenmodul angegeben.

Die Druckschrift WO 2010/122312 A1 betrifft eine Leuchte mit einer hohen Farbqualität

DE102008057347 offenbart Schaltungen mit kombinierten Serien- und Parallelschaltungen von LEDs.

Der Anmeldung liegt die Aufgabe zugrunde, eine verbesserte LED-Beleuchtungsvorrichtung anzugeben, bei der auf Temperaturschwankungen basierende Unterschiede in der Abstrahlcharakteristik mit dem menschlichen Auge nicht wahrnehmbar sind und die gleichzeitig Kostenvorteile bietet. Insbesondere werden Unterschiede im Farbeindruck bei derartigen Vorrichtungen reduziert. Weiterhin wird ein verbessertes Herstellungsverfahren für eine derartige Beleuchtungsvorrichtung angegeben.

Diese Aufgabe wird unter anderem durch eine LED-Beleuchtungsvorrichtung mit den Merkmalen des Anspruchs 1 gelöst. Ferner wird diese Aufgabe durch ein Herstellungsverfahren einer derartigen Beleuchtungsvorrichtung mit den Merkmalen des Anspruchs 9 gelöst. Vorteilhafte Weiterbildungen der Vorrichtung und des Herstellungsverfahrens sind Gegenstand der abhängigen Ansprüche.

In einer Ausführungsform weist die LED-Beleuchtungsvorrichtung zumindest einen ersten LED-Chip und einen zweiten LED-Chip auf, wobei der erste LED-Chip geeignet ist, Strahlung mit einer ersten Abstrahlcharakteristik zu emittieren und der zweite LED-Chip geeignet ist, Strahlung mit einer zweiten Abstrahlcharakteristik zu emittieren. Die erste Abstrahlcharakteristik und die zweite Abstrahlcharakteristik weisen temperaturabhängige Änderungen auf, wobei sich die temperaturabhängige Änderung der ersten Abstrahlcharakteristik und die temperaturabhängige Änderung der zweiten Abstrahlcharakteristik im Betrieb zumindest teilweise kompensieren oder so aufeinander synchronisiert sind, dass der Farbort stabil ist. Stabil kann bedeuten, dass sich der Farbort um höchstens 0,02 oder um höchstens 0,01 Einheiten in der CIE-Normfarbtafel verschiebt.

Die LED-Chips der Beleuchtungsvorrichtung weisen somit unterschiedliche Temperaturabhängigkeiten auf, die im Betrieb der Vorrichtung zumindest teilweise kompensiert werden oder aufeinander synchronisiert sind. Dadurch kann auf eine aufwendige Stromsteuerung beziehungsweise Farbortmessung verzichtet werden, wodurch die Kosten einer derartigen Vorrichtung mit Vorteil erheblich reduziert werden können.

Die LED-Chips der Vorrichtung werden demnach derart intelligent kombiniert, dass das unterschiedliche Temperaturverhalten, das Auswirkungen auf die Abstrahlcharakteristik der einzelnen LED-Chips hat, sich insgesamt nicht auf die von der Vorrichtung emittierte Mischstrahlung auswirkt. Die unterschiedlichen Temperaturverhalten der LED-Chips sind somit in Kombination nicht mit dem bloßen menschlichen Auge wahrnehmbar.

Dabei können die Änderungen der Abstrahlcharakteristiken der einzelnen LED-Chips mit dem bloßen menschlichen Auge wahrnehmbar sein. Die von der Vorrichtung emittierte Mischstrahlung setzt sich vorteilhafterweise durch eine Überlagerung der von den einzelnen LED-Chips emittierten Strahlungen zusammen, so dass die mit dem bloßen Auge wahrnehmbaren Änderungen der einzelnen LED-Chips sich insgesamt zumindest teilweise aufheben.

Die erste und zweite Abstrahlcharakteristik der LED-Chips bezieht sich beispielsweise auf die Helligkeitsempfindlichkeitskurve des Auges bezogene Eigenschaften, wie beispielsweise Farbwiedergabeindex, Lichtstrom, Farbtemperatur, Farbort, Lichtstärke oder Leuchtdichte.

Unter Farbwiedergabeindex, auch bekannt unter dem Begriff "Colour Rendering Index" (CRI), versteht man eine fotometrische Größe, mit der sich die Qualität der Farbwiedergabe von strahlungsemittierenden Bauelementen gleicher korrelierter Farbtemperatur beschreiben lässt. Die Farbtemperatur ist dabei ein Maß für den Farbeindruck einer Lichtquelle.

Der Lichtstrom ist eine fotometrische Größe, die die Wellenlängenabhängigkeit der Empfindlichkeit des menschlichen Auges, also die V(λ)-Kurve, berücksichtigt.

Unter dem "Farbort" werden insbesondere die Zahlenwerte verstanden, die die Farbe der emittierten Strahlung im CIE-Farbraum beschreiben.

Die Änderungen in der Abstrahlcharakteristik können beispielsweise mit zunehmender Temperatur aufgrund einer Erniedrigung der Betriebsspannung eines LED-Chips bei konstantem Strom auftreten. Diese Erniedrigung der Betriebsspannung erfolgt aufgrund der kleiner werdenden Bandlücke sowie aufgrund des abnehmenden Kontaktwiderstands. Dieser Effekt ist dem Fachmann auch unter dem Begriff "negativer Temperaturkoeffizient" bekannt.

Die Betriebsspannung hängt zudem von der Querleitfähigkeit der verwendeten Schichten der LED-Chips ab. Diese Querleitfähigkeit sinkt mit zunehmender Temperatur wegen der Verringerung der mittleren freien Weglänge der Ladungsträger. Dieser Effekt ist dem Fachmann auch unter dem Begriff "positiver Temperaturkoeffizient" bekannt. Die die Betriebsspannung bestimmenden Parameter eines LED-Chips besitzen also unterschiedliche Temperaturabhängigkeiten, wobei sich diese Temperaturabhängigkeiten je nach Ausgestaltung beziehungsweise Design der einzelnen LED-Chips verändern lassen.

Die einzelnen LED-Chips der LED-Vorrichtung werden dabei derart ausgestaltet, dass sich die resultierenden Temperaturabhängigkeiten der LED-Chips insgesamt kompensieren oder diese synchron zueinander verlaufen, sodass ein konstanter Farbort der von der Vorrichtung emittierten Strahlung gewährleistet werden kann. Ist beispielsweise vorgesehen, dass der positive Temperaturkoeffizient eines LED-Chips überwiegen soll, so muss der absolute Betriebsstrom erhöht werden, da so der Anteil des Serienwiderstands, der durch die Querleitfähigkeit vorgegeben ist, gegenüber dem Bandlückenanteil überwiegt.

In einer Weiterbildung emittiert die LED-Beleuchtungsvorrichtung temperaturunabhängig im Betrieb gleichfarbiges Licht. Die LED-Beleuchtungsvorrichtung emittiert insbesondere Mischstrahlung der von dem ersten LED-Chip emittierten Strahlung und der von dem zweiten LED-Chip emittierten Strahlung. Die Abstrahlcharakteristik der Mischstrahlung weist dabei im Wesentlichen keine Temperaturabhängigkeiten auf, da sich die Temperaturabhängigkeiten der einzelnen LED-Chips im Betrieb kompensieren oder aufeinander synchronisiert sind. So kann eine LED-Beleuchtungsvorrichtung erzielt werden, die mit zunehmender sowie abnehmender Temperatur Mischstrahlung mit gleichem Farbort emittiert. Der üblicherweise mit steigender Temperatur auftretende Blaustich beziehungsweise der mit sinkender Temperatur auftretende Rotstich kann so reduziert beziehungsweise vermieden werden.

In einer Weiterbildung emittiert die LED-Beleuchtungsvorrichtung temperaturunabhängig eine Mischstrahlung mit einem konstanten Farbort. Der von der Vorrichtung emittierte Farbort ist somit unabhängig von einer im Betrieb auftretenden Temperaturveränderung. Mit konstantem Farbort bedeutet dabei insbesondere, dass die Mischstrahlung abhängig von der Augenempfindlichkeitsverteilung des menschlichen Auges einen konstanten Farbort aufweist, der also geringe Abweichungen aufweisen kann, die jedoch mit dem menschlichen Auge nicht wahrnehmbar sind.

In einer Weiterbildung ist die Änderung der Abstrahlcharakteristiken eine Verschiebung der emittierten Wellenlänge und/oder eine Leistungsänderung.

Der erste LED-Chip emittiert insbesondere Strahlung einer ersten Wellenlänge. Der zweite LED-Chip emittiert Strahlung einer zweiten Wellenlänge, die vorzugsweise von der ersten Wellenlänge verschieden ist. Die erste Wellenlänge und die zweite Wellenlänge verschieben sich im Betrieb der Vorrichtung temperaturabhängig, wobei vorteilhafterweise die Verschiebung der ersten Wellenlänge die Verschiebung der zweiten Wellenlänge kompensiert oder diese synchron zueinander verlaufen, so dass die Mischstrahlung unabhängig von der Temperaturveränderung eine ähnliche Farbtemperatur aufweist. Unter ähnlicher Farbtemperatur ist insbesondere zu verstehen, dass eine eventuell auftretende Schwankung der Farbtemperatur mit dem bloßen menschlichen Auge nicht wahrnehmbar ist.

In einer Weiterbildung ist die temperaturabhängige Änderung der ersten Abstrahlcharakteristik der temperaturabhängigen Änderung der zweiten Abstrahlcharakteristik entgegengerichtet oder verläuft synchron zur temperaturabhängigen Änderung der zweiten Abstrahlcharakteristik. Durch Überlagerung der von den LED-Chips emittierten Strahlungen heben sich so beispielsweise die temperaturabhängige Änderung des ersten LED-Chips und die temperaturabhängige Änderung des zweiten LED-Chips gegeneinander zumindest teilweise auf.

Die LED-Chips weisen jeweils bevorzugt eine Halbleiterschichtenfolge auf, die eine aktive Schicht enthält. Die Halbleiterschichtenfolge enthält dabei mindestens ein III/V-Halbleitermaterial zur Strahlungserzeugung. Die aktive Schicht enthält jeweils vorzugsweise einen pn-Übergang, eine Doppelheterostruktur, eine Einfachquantentopfstruktur (SQW, Single Quantum Well) oder eine Mehrfachquantentopfstruktur (MQW, Multi Quantum Well) zur Strahlungserzeugung. Die Bezeichnung Quantentopfstruktur entfaltet hierbei keine Bedeutung hinsichtlich der Dimensionalität der Quantisierung. Sie umfasst unter anderem Quantentröge, Quantendrähte und Quantenpunkte und jede Kombination dieser Strukturen.

In einer Weiterbildung emittiert der erste LED-Chip mintfarbene Strahlung. Beispielsweise liegt die von dem ersten LED-Chip emittierte Strahlung in einem Wellenlängenbereich zwischen 480 und 520 nm.

In einer Weiterbildung emittiert der zweite LED-Chip amberfarbene Strahlung. Beispielsweise liegt die von dem zweiten LED-Chip emittierte Strahlung in einem Wellenlängenbereich zwischen 600 und 630 nm, vorzugsweise 615 nm.

Zur Kompensation beziehungsweise Synchronisation der temperaturabhängigen Verhalten des ersten und zweiten LED-Chips wird dabei der mintfarbene LED-Chip so ausgestaltet, dass mit zunehmender Temperatur die Spannung zunimmt und die Spannung der amberfarbenen LED-Chips abnimmt. Beispielsweise nimmt durch diese Ausgestaltung das Licht des amberfarbenen LED-Chips weniger ab als ohne Kompensation. Im Idealfall entspricht dadurch die Lichtabnahme des amberfarbenen LED-Chips der Lichtabnahme des mintfarbenen LED-Chips. Hierdurch werden vorteilhafterweise die Temperaturabhängigkeit der verwendeten LED-Chips synchronisiert.

Alternativ emittiert der erste LED-Chip blaue Strahlung und der zweite LED-Chip rote Strahlung. Hierbei ist zu beachten, dass die Leistung eines blauen LED-Chips mit steigender Temperatur weniger abnimmt als die Leistung des roten LED-Chips. Die LED-Chips werden daher derart ausgestaltet, dass die Leistungsabnahme dieser LED-Chips synchron zueinander verläuft, sodass die von der Vorrichtung emittierte Mischstrahlung einen stabilen Farbort aufweist.

In einer Weiterbildung emittiert die LED-Beleuchtungsvorrichtung Mischstrahlung im weißen Spektralbereich, vorzugsweise im warmweißen Spektralbereich. Die Mischstrahlung ist dabei unabhängig von einer im Betrieb auftretenden Temperaturveränderung.

Ein Verfahren zum Herstellung zumindest einer LED-Beleuchtungsvorrichtung, die einen ersten LED-Chip und einen zweiten LED-Chip umfasst, weist folgende Verfahrensschritte auf:
- Herstellen einer Mehrzahl von ersten LED-Chips, die geeignet sind, jeweils Strahlung mit einer ersten Abstrahlcharakteristik zu emittieren,
- Herstellen einer Mehrzahl von zweiten LED-Chips, die geeignet sind, jeweils Strahlung mit einer zweiten Abstrahlcharakteristik zu emittieren,
- Messen von temperaturabhängigen Änderungen der ersten Abstrahlcharakteristiken der ersten LED-Chips,
- Messen von temperaturabhängigen Änderungen der zweiten Abstrahlcharakteristiken der zweiten LED-Chips, und
- Kombinieren der LED-Chips zu Gruppen von jeweils mindestens einem ersten LED-Chip und einem zweiten LED-Chip derart, dass sich die temperaturabhängige Änderung der ersten Abstrahlcharakteristik und die temperaturabhängige Änderung der zweiten Abstrahlcharakteristik zumindest teilweise kompensieren oder synchron zueinander verlaufen.

Die in Verbindung mit der LED-Beleuchtungsvorrichtung genannten Merkmale und Vorteile gelten auch für das Verfahren, und umgekehrt.

Durch die intelligente Kombination von LED-Chips mit unterschiedlichen Temperaturverhalten können Änderungen in der Abstrahlcharakteristik derart aufgehoben oder synchronisiert werden, dass die LED-Vorrichtung insgesamt Mischstrahlung emittiert, die temperaturabhängig eine für das menschliche Auge konstante Abstrahlcharakteristik aufweist.

Die Selektion der LED-Chips einer Beleuchtungsvorrichtung erfolgt vorteilhafterweise so, dass die temperaturbedingte Leistungsabnahme der LED-Chips ähnlich oder gleich ist. Dies erfolgt beispielsweise durch Wahl des Betriebsstroms bei einer Anordnung der LED-Chips in einer Reihenschaltung, durch Wahl der Operationsspannung bei einer Anordnung der LED-Chips in einer Parallelschaltung oder durch eine Selektion passender LED-Chips für die Beleuchtungsvorrichtung. Alternativ kann die Kompensation oder Synchronisation der temperaturabhängigen Änderungen der LED-Chips durch das Design der LED-Chips erzielt werden. Beispielsweise wird hierzu die Temperaturabhängigkeit des Stroms von der Spannung eingestellt beziehungsweise verändert. Dies erfolgt beispielsweise über die Gewichtung von Serienwiderstand zur Spannung und zum Kontakt-Schottky-Widerstand.

In einer Weiterbildung emittiert die LED-Beleuchtungsvorrichtung temperaturunabhängig im Betrieb gleichfarbiges Licht. Temperaturabhängige Verschiebungen in der Wellenlänge der Mischstrahlung sind dabei vorzugsweise so gering, dass die emittierte Mischstrahlung temperaturunabhängig im gleichen Farbortbereich liegt.

In einer Weiterbildung wird der erste LED-Chip derart ausgebildet wird, dass dieser die temperaturabhängige Änderung der zweiten Abstrahlcharakteristik des zweiten LED-Chips kompensiert oder synchron hierzu verläuft. Der erste LED-Chip wird dabei derart ausgebildet, dass sich seine resultierende Temperaturabhängigkeit derart verändert, dass diese der Temperaturabhängigkeit des zweiten LED-Chips entgegengerichtet ist oder synchron dazu verläuft.

Beispielsweise ist der erste LED-Chip ein mintfarbener LED-Chip, bei dem zur Kompensation ein lateraler Abstand zwischen n-Kontakt und p-Kontakt erhöht wird. Dadurch erhöht sich in der Temperaturabhängigkeit des ersten LED-Chips der Anteil des Serienwiderstandes mit positivem Temperaturkoeffizient. Ist der zweite LED-Chip ein amberfarbener LED-Chip, so verläuft mittels eines derart ausgestalteten mintfarbenen LED-Chips das Temperaturverhalten des ersten LED-Chips synchron zum Temperaturverhalten des zweiten LED-Chips.

Alternativ wird zur Kompensation oder Synchronisation der erste LED-Chip derart ausgebildet, dass der Betriebsstrom des ersten LED-Chips erhöht wird. Auch damit erzielt man in der Temperaturabhängigkeit des ersten LED-Chips eine Erhöhung des Anteils des Serienwiderstandes mit positivem Temperaturkoeffizient, womit das Temperaturverhalten des amberfarbenen LED-Chips und des mintfarbenen LED-Chips zueinander synchronisiert werden kann.

In einer Weiterbildung werden in einem gemeinsamen Verfahren eine Mehrzahl von LED-Beleuchtungsvorrichtungen hergestellt, wobei jeweils eine LED-Beleuchtungsvorrichtung mindestens einen ersten LED-Chip und einen zweiten LED-Chip umfasst, die jeweils derart kombiniert werden, dass sich die temperaturabhängige Änderung der ersten Abstrahlcharakteristik des ersten LED-Chips und die temperaturabhängige Änderung der zweiten Abstrahlcharakteristik des zweiten LED-Chips zumindest teilweise kompensieren oder synchron zueinander verlaufen. Hierzu kann beispielsweise der erste LED-Chip derart ausgestaltet sein, dass das von dem ersten LED-Chip emittierte Licht temperaturabhängig weniger abnimmt, sodass im Idealfall dieser Lichtabfall dem Lichtabfall des zweiten LED-Chips entspricht oder zumindest ähnlich zu diesem verläuft. Mögliche Ausgestaltungen der LED-Chips sind bereits weiter vorne in dieser Patentanmeldung erörtert und werden daher an dieser Stelle nicht weiter erläutert.

In einer Weiterbildung werden die LED-Beleuchtungsvorrichtung jeweils mit einer Gruppe von LED-Chips bestückt. Die Gruppe von LED-Chips setzt sich dabei zumindest aus einem ersten LED-Chip und einem zweiten LED-Chip zusammen.

Weitere Vorteile und vorteilhafte Weiterbildungen der Erfindung ergeben sich aus den im Folgenden in Verbindung mit den Figuren 1 bis 3 beschriebenen Ausführungsbeispielen. Es zeigen:
- Figur 1: einen schematischen Querschnitt eines Ausführungsbeispiels einer erfindungsgemäßen LED-Beleuchtungsvorrichtung,
- Figur 2: ein schematisches Flussdiagramm in Verbindung mit einem erfindungsgemäßen Herstellungsverfahren, und
- Figur 3: ein Diagramm betreffend die Temperaturabhängigkeit der Spannung bei verschiedenen Strömen.

In den Figuren können gleiche oder gleichwirkende Bestandteile jeweils mit den gleichen Bezugszeichen versehen sein. Die dargestellten Bestandteile und deren Größenverhältnisse untereinander sind grundsätzlich nicht als maßstabsgerecht anzusehen. Vielmehr können einzelne Bestandteile, wie beispielsweise Schichten, Strukturen, Komponenten und Bereiche, zur besseren Darstellbarkeit und/oder zum besseren Verständnis übertrieben dick oder groß dimensioniert dargestellt sein.

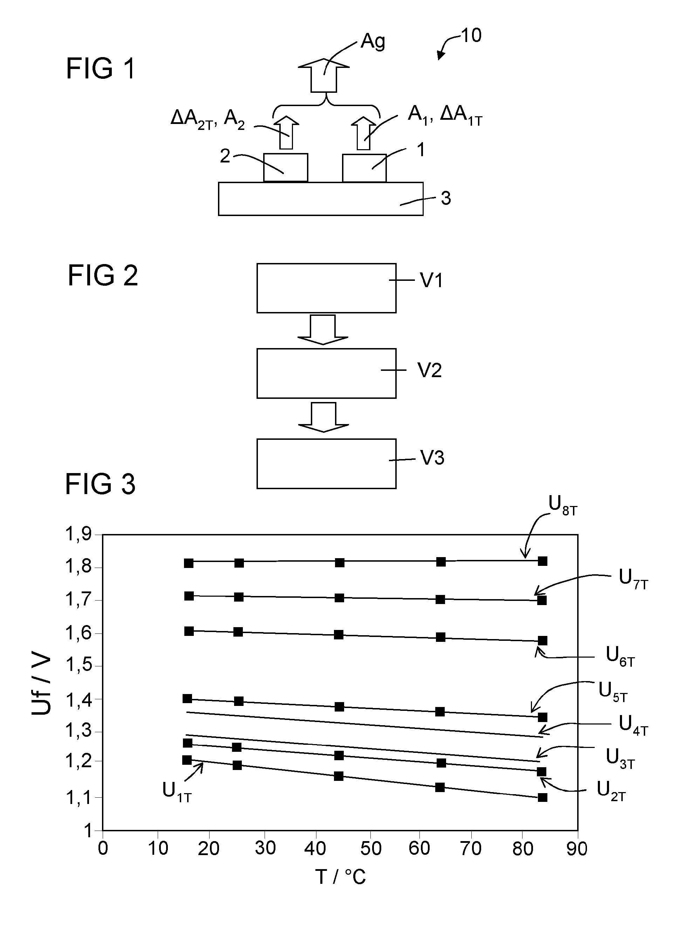

In Figur 1 ist eine LED-Beleuchtungsvorrichtung 10 gezeigt, die einen Trägerkörper 3, einen darauf angeordneten ersten LED-Chip 1 und einen auf dem Trägerkörper 3 angeordneten zweiten LED-Chip 2 aufweist. Der Trägerkörper 3 ist beispielsweise eine Leiterplatte oder ein PCB (Printed Circuit Board). Alternativ können auf dem Trägerkörper 3 eine Mehrzahl von LED-Chips angeordnet sein (nicht dargestellt).

Die LED-Chips 1, 2 weisen jeweils eine aktive Schicht auf, die geeignet ist, elektromagnetische Strahlung im Betrieb zu erzeugen. Die LED-Chips 1, 2 sind beispielsweise in Dünnfilmbauweise ausgeführt. Insbesondere umfassen die LED-Chips 1, 2 bevorzugt epitaktisch abgeschiedene Schichten, die jeweils den LED-Chip bilden. Die Schichten der LED-Chips 1, 2 basieren bevorzugt auf einem III/V-Verbindungshalbleitermaterial.

Die LED-Chips 1, 2 weisen jeweils eine Strahlungsaustrittsseite auf, die von dem Trägerkörper 3 abgewandt ist. Aus der Strahlungsaustrittsseite tritt vorzugsweise jeweils größtenteils die von den LED-Chips emittierte Strahlung aus. Beispielsweise sind die LED-Chips 1, 2 oberflächenemittierende Chips.

Der erste LED-Chip 1 ist geeignet, im Betrieb Strahlung mit einer ersten Abstrahlcharakteristik A1 zu emittieren. Der zweite LED-Chip 2 ist geeignet, im Betrieb Strahlung mit einer zweiten Abstrahlcharakteristik A2 zu emittieren. Die Abstrahlcharakteristiken A1, A2 umfassen dabei beispielsweise die Wellenlänge, den Farbort und/oder die Helligkeit der von den LED-Chips 1, 2 emittierten Strahlung.

Der erste LED-Chip 1 emittiert vorzugsweise mintfarbene Strahlung in einem Wellenlängenbereich zwischen 480 und 520 nm. Der zweite LED-Chip 2 emittiert bevorzugt amberfarbene Strahlung in einem Wellenlängenbereich zwischen 600 nm und 630 nm, vorzugsweise 615 nm. Eine Kombination eines mintfarbenen LED-Chips mit einem amberfarbenen LED-Chip eignet sich insbesondere zur Erzeugung einer Mischstrahlung mit einem warmweißen Farbort. Insbesondere überlagert sich im Betrieb die von dem ersten LED-Chip 1 emittierte Strahlung mit der von dem zweiten LED-Chip 2 emittierte Strahlung, so dass die Beleuchtungsvorrichtung insgesamt Mischstrahlung Ag emittiert.

Die LED-Chips 1, 2 verhalten sich bei unterschiedlichen Temperaturen unterschiedlich. Beispielsweise nimmt die emittierte Leistung unterschiedlich ab und/oder die Wellenlängen der emittierten Strahlung verschieben sich unterschiedlich. Insbesondere weisen die erste Abstrahlcharakteristik A1 und die zweite Abstrahlcharakteristik A2 temperaturabhängige Änderungen ΔA_{1T}, ΔA_{2T} auf. Derartige temperaturabhängige Änderungen führen herkömmlicherweise zu einer Veränderung des Farborts der Mischstrahlung Ag. Beispielsweise wird die ursprünglich warmweiße Strahlung blaustichig, wenn die Temperatur steigt, oder rotstichig, wenn die Temperatur sinkt.

Dieser Effekt wird mit der vorliegenden Vorrichtung 10 verringert oder vermieden, indem sich die temperaturabhängige Änderung ΔA_{1T} der ersten Abstrahlcharakteristik A1 und die temperaturabhängige Änderung ΔA_{2T} der zweiten Abstrahlcharakteristik A2 im Betrieb zumindest teilweise kompensieren oder synchron zueinander verlaufen. Aufgrund dieser Kompensation oder Synchronisation der Änderungen kann eine Beleuchtungsvorrichtung erzielt werden, die vorzugsweise temperaturunabhängig im Betrieb gleichfarbiges Licht emittiert. Die LED-Beleuchtungsvorrichtung 10 emittiert somit temperaturunabhängig eine Mischstrahlung Ag mit einem konstanten Farbort. Konstanter Farbort bedeutet insbesondere, dass Abweichungen im Farbort mit dem bloßen menschlichen Auge nicht wahrnehmbar sind. Die Beleuchtungsvorrichtung, insbesondere die Mischstrahlung, ist somit insbesondere unabhängig von einer im Betrieb auftretenden Temperaturveränderung.

Dabei können die Änderungen der ersten Abstrahlcharakteristik A1 und der zweiten Abstrahlcharakteristik A2 zwar mit dem menschlichen Auge wahrnehmbar sein, die Überlagerung der von den LED-Chips emittierten Strahlungen, also die Mischstrahlung A_{g}, weist dabei jedoch höchstens eine temperaturabhängige Änderung auf, die mit dem bloßen menschlichen Auge abhängig von der Augenempfindlichkeitskurve nicht wahrnehmbar ist.

Um eine derartige Kompensation oder Synchronität der Änderungen der Abstrahlcharakteristiken zu bewirken, ist die temperaturabhängige Änderung ΔA_{1T} der ersten Abstrahlcharakteristik A1 der temperaturabhängigen Änderung ΔA_{2T} Änderung der zweiten Abstrahlcharakteristik A2 entgegengerichtet oder synchron zueinander gerichtet. Der erste LED-Chip 1 wird somit so ausgebildet, dass mit zunehmender Temperatur die Spannung zunimmt, für den Fall, dass mit zunehmender Temperatur die emittierte Leistung bei gleichem beziehungsweise unverändertem Strom weniger stark abnimmt als die emittierte Leistung des zweiten LED-Chips 2. Dadurch reduzieren sich Strom und damit Licht des ersten LED-Chips mit zunehmender Temperatur, sodass sich die Leistungsabnahme des ersten LED-Chips 1 an die Leistungsabnahme des zweiten LED-Chips 2 angleicht. Hierdurch kann erzielt werden, dass die Temperaturabhängigkeiten hinsichtlich der Leistung des zweiten LED-Chips und des ersten LED-Chips synchronisiert werden, und so der Farbort temperaturunabhängig stabil bleibt.

Die Änderung ΔA_{1T}, ΔA_{2T} der Abstrahlcharakteristiken A1, A2 zeigt sich beispielsweise durch eine Verschiebung der emittierten Wellenlänge, also des Farborts, und/oder durch eine Leistungsänderung.

Beispielsweise emittiert der erste LED-Chip Strahlung einer ersten Wellenlänge und der zweiten LED-Chip Strahlung einer zweiten Wellenlänge, die sich von der ersten Wellenlänge unterscheidet. Im Betrieb der LED-Chips verschieben sich temperaturabhängig die erste Wellenlänge und die zweite Wellenlänge, wobei die Verschiebung der ersten Wellenlänge der Verschiebung der zweiten Wellenlänge derart entgegengerichtet ist oder zu dieser synchron verläuft, dass sich insgesamt die Verschiebungen zumindest teilweise kompensieren beziehungsweise synchronisieren, so dass die Vorrichtung Mischstrahlung mit einem konstanten Farbort emittiert, die sich aus einer Überlagerung der Strahlung des ersten LED-Chips und der emittierten Strahlung des zweiten LED-Chips zusammensetzt.

Die LED-Chips einer Beleuchtungsvorrichtung werden somit derart ausgebildet, dass ermittelte Temperaturabhängigkeiten in der von der Vorrichtung 10 emittierten Mischstrahlung nicht sichtbar sind. Es werden also LED-Chips mit unterschiedlichen Temperaturabhängigkeiten so kombiniert, dass auf eine aufwendige Stromsteuerung beziehungsweise Farbortmessung im Betrieb der LED-Chips verzichtet werden kann, wodurch sich die Kosten einer derartigen Weißlichtvorrichtung vorteilhafterweise reduzieren.

Zur Kompensation oder Synchronisation der Änderungen in der Abstrahlcharakteristik kann beispielsweise der erste LED-Chip 1 derart ausgebildet sein, dass ein lateraler Abstand zwischen n-Kontakt und p-Kontakt des ersten LED-Chips 1 erhöht wird. Aufgrund dieser Erhöhung erhöht sich mit Vorteil der Anteil des Serienwiderstands mit positiven Temperaturkoeffizienten in der Temperaturabhängigkeit des ersten LED-Chips, wodurch der Temperaturabhängigkeit des zweiten LED-Chips entgegengewirkt oder diese synchronisiert werden kann.

Alternativ oder zusätzlich kann der erste LED-Chip zur Kompensation oder Synchronisation derart ausgebildet sein, dass der Betriebsstrom des ersten LED-Chips 1 erhöht wird. Dadurch kann ebenfalls der Effekt der Erhöhung des Anteils des Serienwiderstandes mit positiven Temperaturkoeffizienten in der Temperaturabhängigkeit des LED-Chips erzielt werden. Das kann zum Beispiel dadurch erzeugt werden, indem der erste LED-Chip 1 in Serie verschaltet ist mit einer Mehrzahl von zweiten LED-Chips 2, die untereinander parallel geschaltet sind (nicht dargestellt). So teilt sich der Strom, der komplett durch den ersten LED-Chip 1 fliest, auf die zweiten LED-Chips 2 auf, sodass die Stromstärke durch die zweiten LED-Chips 2 geringer ist als die Stromstärke durch den ersten LED-Chip 1. Allgemein kann eine Mehrzahl von n ersten LED-Chips, die untereinander parallel geschaltet sind, in Serie verschaltet sein mit einer Mehrzahl von m zweiten LED-Chips, die auch untereinander parallel geschaltet sind, wobei n kleiner als m ist. Dabei bezeichnen n und m jeweils die Anzahl oder Stückzahl der jeweiligen LED-Chips 1, 2.

In Figur 2 ist ein Flussdiagramm zur Herstellung einer LED-Beleuchtungsvorrichtung gezeigt, wie sie beispielsweise in dem Ausführungsbeispiel der Figur 1 dargestellt ist. Im Verfahrensschritt V1 werden eine Mehrzahl von ersten LED-Chips und eine Mehrzahl von zweiten LED-Chips hergestellt, die jeweils geeignet sind, Strahlung mit einer ersten beziehungsweise zweiten Abstrahlcharakteristik zu emittieren. Die ersten LED-Chips sind vorzugsweise mintfarbene LED-Chips, die also Strahlung im mintfarbenen Farbortbereich emittieren. Die zweiten LED-Chips sind vorzugsweise amberfarbene LED-Chips, also LED-Chips, die Strahlung im amberfarbenen Farbortbereich emittieren.

Nach Fertigstellung der ersten und zweiten LED-Chips werden im Verfahrensschritt V2 die temperaturabhängigen Änderungen der ersten beziehungsweise zweiten Abstrahlcharakteristiken gemessen.

Im Verfahrensschritt V3 werden anschließend die LED-Chips zu Gruppen von jeweils mindestens einem ersten LED-Chip und einem zweiten LED-Chip kombiniert. Dabei werden die LED-Chips mit unterschiedlichen Temperaturverhalten derart kombiniert, dass eine Kompensation oder Synchronität der unterschiedlichen Temperaturverhalten erzielt werden kann. Insbesondere werden die Gruppen von LED-Chips derart kombiniert, dass sich die temperaturabhängige Änderung der ersten Abstrahlcharakteristik des ersten LED-Chips und die temperaturabhängige Änderung der zweiten Abstrahlcharakteristik des zweiten LED-Chips zumindest teilweise kompensieren oder zueinander synchron verlaufen. Beispielsweise kompensieren sich die Änderungen vollständig.

Es findet also im Herstellungsverfahren aufgrund von Messungen der Temperaturabhängigkeiten der Abstrahlcharakteristiken eine intelligente Kombination der einzelnen LED-Chips statt, so dass eine LED-Beleuchtungsvorrichtung erzielt werden kann, die temperaturunabhängig im Betrieb gleichfarbiges Licht emittiert. Unabhängig von einer im Betrieb auftretenden Temperaturveränderung weist die von der Vorrichtung emittierte Mischstrahlung so einen nahezu konstanten Farbort auf.

Das Herstellungsverfahren gemäß dem Ausführungsbeispiel der Figur 2 eignet sich auch zur Herstellung einer Mehrzahl von LED-Beleuchtungsvorrichtungen in einem gemeinsamen Verfahren. Dabei werden vorzugsweise jeweils eine LED-Beleuchtungsvorrichtung mit einer Gruppe von LED-Chips bestückt, wobei die LED-Chips der einzelnen Beleuchtungsvorrichtungen derart kombiniert sind, dass sich die temperaturabhängigen Änderungen in den Abstrahlcharakteristiken jeweils kompensieren oder synchron zueinander verlaufen, so dass jede Beleuchtungsvorrichtung im Betrieb temperaturunabhängig gleichfarbiges Licht emittiert.

In Figur 3 ist die Temperaturabhängigkeit der Spannung bei verschiedenen Strömen in einem Diagramm dargestellt. Insbesondere sind acht Messkurven U_{1T} bis U_{8T} in dem Diagramm eingezeichnet, wobei sich der Strom von U_{1T} bis U_{8T} von 1 mA bis 1000 mA erhöht. Die Messkurve U_{1T} basiert auf Strömen von 1 mA, die Messkurve U_{2T} auf Strömen von 5 mA, die Messkurve U_{3T} auf Strömen von 10 mA, die Messkurve U_{4T} auf Strömen von 50 mA, die Messkurve U_{5T} auf Strömen von 100 mA, die Messkurve U_{6T} auf Strömen von 500 mA, die Messkurve U_{7T} auf Strömen von 750 mA und die Messkurve U_{8T} auf Strömen von 1000 mA.

Wie in dem Diagramm gezeigt, nimmt für kleine Ströme die Spannung mit zunehmender Temperatur ab, siehe beispielsweise die Messkurven von U_{1T} bis U_{6T}. Bei Strömen zwischen 750 mA, vorliegend als U_{7T}, und 1000 mA, vorliegend als U_{8T}, verschwindet die Temperaturabhängigkeit. Bei Strömen von über 1000 mA nimmt die Spannung zu (nicht dargestellt).

Eine Ermittlung beziehungsweise Bestimmung dieser Temperaturabhängigkeiten abhängig vom Betriebsstrom kann dazu verwendet werden, die LED-Chips für eine erfindungsgemäße Beleuchtungsvorrichtung, wie in Verbindung mit den Ausführungsbeispielen der Figuren 1 und 2 erläutert, intelligent zu kombinieren.

Die Erfindung ist nicht durch die Beschreibung anhand der Ausführungsbeispiele auf diese beschränkt, sondern umfasst jedes neue Merkmal sowie jede Kombination von Merkmalen, was Patentansprüchen beinhaltet, auch wenn diese Merkmale oder diese Kombinationen selbst nicht explizit in den Patentansprüchen oder Ausführungsbeispielen angegeben sind. Diese Patentanmeldung beansprucht die Priorität der deutschen Patentanmeldung 10 2011 010 752 .5.

## Patentansprüche

1. LED-Beleuchtungsvorrichtung (10) mit zumindest einem ersten LED-Chip (1) und einer Mehrzahl von zweiten LED-Chips (2), wobei
- der erste LED-Chip (1) geeignet ist, Strahlung mit einer ersten Abstrahlcharakteristik (A1) zu emittieren,
- die zweiten LED-Chips (2) geeignet sind, Strahlung mit einer zweiten Abstrahlcharakteristik (A2) zu emittieren,
- die erste Abstrahlcharakteristik (A1) und die zweite (A2) Abstrahlcharakteristik temperaturabhängige Änderungen (ΔA_{1T}, ΔA_{2T}) aufweisen,
- sich die temperaturabhängige Änderung (ΔA_{1T}) der ersten Abstrahlcharakteristik (A1) und die temperaturabhängige Änderung (ΔA_{2T}) der zweiten Abstrahlcharakteristik (A2) im Betrieb zumindest teilweise kompensieren oder so aufeinander synchronisiert sind, dass der Farbort einer von der LED-Beleuchtungsvorrichtung (10) emittierten Mischstrahlung (Ag) stabil ist,
- die von dem mindestens einen ersten LED-Chip (1) emittierte Strahlung in einem Wellenlängenbereich zwischen 480 und 520 nm liegt, und
- die von den zweiten LED-Chips (2) emittierte Strahlung in einem Wellenlängenbereich zwischen 600 und 630 nm liegt,
**dadurch gekennzeichnet, dass**
der zumindest eine erste LED-Chip (1) elektrisch in Serie verschaltet ist mit der Mehrzahl von zweiten LED-Chips (2), die untereinander elektrisch parallel geschaltet sind.

2. LED-Beleuchtungsvorrichtung nach Anspruch 1, wobei die LED-Beleuchtungsvorrichtung (10) temperaturunabhängig im Betrieb gleichfarbiges Licht (Ag) emittiert.

3. LED-Beleuchtungsvorrichtung nach Anspruch 1, wobei die LED-Beleuchtungsvorrichtung (10) temperaturunabhängig die Mischstrahlung (Ag) mit einem konstanten Farbort emittiert.

4. LED-Beleuchtungsvorrichtung nach einem der vorhergehenden Ansprüche, wobei
die Änderung (ΔA_{1T}, ΔA_{2T}) der Abstrahlcharakteristiken (A1, A2) eine Verschiebung der emittierten Wellenlänge und/oder eine Leistungsänderung ist.

5. LED-Beleuchtungsvorrichtung nach einem der vorhergehenden Ansprüche, wobei
die temperaturabhängige Änderung (ΔA_{1T}) der ersten Abstrahlcharakteristik (A1) der temperaturabhängigen Änderung (ΔA_{2T}) der zweiten Abstrahlcharakteristik (A2) entgegengerichtet ist oder synchron zu dieser verläuft.

6. LED-Beleuchtungsvorrichtung nach einem der vorhergehenden Ansprüche, wobei
der erste LED-Chip (1) mintfarbene Strahlung emittiert die zweiten LED-Chips (2) amberfarbene Strahlung emittieren.

7. LED-Beleuchtungsvorrichtung nach einem der vorhergehenden Ansprüche, wobei
eine Mehrzahl von n ersten LED-Chips (1), die untereinander parallel geschaltet sind, in Serie verschaltet ist mit einer Mehrzahl von m zweiten LED-Chips (2), die auch untereinander parallel geschaltet sind, wobei n kleiner als m ist und n und m jeweils die Anzahl der jeweiligen LED-Chips (1, 2) bezeichnen,
wobei eine Stromstärke durch die zweiten LED-Chips (2) geringer ist als die Stromstärke durch die ersten LED-Chips (1).

8. LED-Beleuchtungsvorrichtung nach einem der vorhergehenden Ansprüche,
die Mischstrahlung (Ag) im weißen Spektralbereich emittiert.

9. Verfahren zum Herstellen zumindest einer LED-Beleuchtungsvorrichtung (10), die einen ersten LED-Chip (1) und eine Mehrzahl von zweiten LED-Chips (2) umfasst, mit den Verfahrensschritten:
- Herstellen einer Mehrzahl von ersten LED-Chips (1), die geeignet sind, jeweils Strahlung mit einer ersten Abstrahlcharakteristik (A1) zu emittieren,
- Herstellen einer Vielzahl von zweiten LED-Chips (2), die geeignet sind, jeweils Strahlung mit einer zweiten Abstrahlcharakteristik (A2) zu emittieren,
- Messen von temperaturabhängigen Änderungen (ΔA_{1T}) der ersten Abstrahlcharakteristiken (A1) der ersten LED-Chips (1),
- Messen von temperaturabhängigen Änderungen (ΔA_{2T}) der zweiten Abstrahlcharakteristiken (A2) der zweiten LED-Chips (2), und
- Kombinieren der LED-Chips (1, 2) zu Gruppen von jeweils mindestens einem ersten LED-Chip (1) und der Mehrzahl der zweiten LED-Chips (2) derart, dass sich die temperaturabhängige Änderung (ΔA_{1T}) der ersten Abstrahlcharakteristik (A1) des ersten LED-Chips (1) und die temperaturabhängige Änderung (ΔA_{2T}) der zweiten Abstrahlcharakteristik (A2) der Mehrzahl der zweiten LED-Chips (2) zumindest teilweise kompensieren oder synchron zueinander verlaufen,
wobei die von dem mindestens einen ersten LED-Chip (1) emittierte Strahlung in einem Wellenlängenbereich zwischen 480 und 520 nm liegt und die von den zweiten LED-Chips (2) emittierte Strahlung in einem Wellenlängenbereich zwischen 600 und 630 nm liegt, **dadurch gekennzeichnet, dass**
der zumindest eine erste LED-Chip (1) elektrisch in Serie verschaltet ist mit der Mehrzahl von zweiten LED-Chips (2), die untereinander elektrisch parallel geschaltet sind.

10. Verfahren nach Anspruch 9, wobei
die LED-Beleuchtungsvorrichtung (10) temperaturunabhängig im Betrieb gleichfarbiges Licht (Ag) emittiert.

11. Verfahren nach Anspruch 9 oder 10, wobei
der erste LED-Chip (1) derart ausgebildet wird, dass dieser die temperaturabhängige Änderung (ΔA_{2T}) der zweiten Abstrahlcharakteristik (A2) des zweiten LED-Chips (2) kompensiert oder synchronisiert.

12. Verfahren nach Anspruch 11, wobei
zur Kompensation ein lateraler Abstand zwischen n-Kontakt und p-Kontakt des ersten LED-Chips (1) erhöht wird.

13. Verfahren nach Anspruch 11, wobei
zur Kompensation der Betriebsstrom des ersten LED-Chips (1) erhöht wird.

14. Verfahren nach einem der vorhergehenden Ansprüche 9 bis 13, bei dem in einem gemeinsamen Verfahren eine Mehrzahl von LED-Beleuchtungsvorrichtungen (10) hergestellt wird.

15. Verfahren nach Anspruch 14, mit dem zusätzlichen Verfahrensschritt:
- Bestücken jeweils einer LED-Beleuchtungsvorrichtung (10) mit einer Gruppe von LED-Chips (1, 2).

## Claims

1. LED lighting device (10) comprising at least one first LED chip (1) and a plurality of second LED chips (2), wherein
- the first LED chip (1) is suitable for emitting radiation having a first emission characteristic (A1),
- the second LED chips (2) are suitable for emitting radiation having a second emission characteristic (A2),
- the first emission characteristic (A1) and the second emission characteristic (A2) have temperature-dependent changes (ΔA_{1T}, ΔA_{2T}),
- the temperature-dependent change (ΔA_{1T}) of the first emission characteristic (A1) and the temperature-dependent change (ΔA_{2T}) of the second emission characteristic (A2) during operation at least partly compensate for one another or are synchronized with one another such that the colour locus of a mixed radiation (Ag) emitted by the LED lighting device (10) is stable,
- the radiation emitted by the at least one first LED chip (1) is in a wavelength range of between 480 and 520 nm, and
- the radiation emitted by the second LED chips (2) is in a wavelength range of between 600 and 630 nm,
**characterized in that**
the at least one first LED chip (1) is electrically interconnected in series with the plurality of second LED chips (2), which are electrically connected in parallel among one another.

2. LED lighting device according to Claim 1, wherein
the LED lighting device (10) emits identically coloured light (Ag) during operation in a temperature-independent manner.

3. LED lighting device according to Claim 1, wherein
the LED lighting device (10) emits the mixed radiation (Ag) with a constant colour locus in a temperature-independent manner.

4. LED lighting device according to any of the preceding claims, wherein
the change (ΔA_{1T}, ΔA_{2T}) in the emission characteristics (A1, A2) is a shift of the emitted wavelength and/or a power change.

5. LED lighting device according to any of the preceding claims, wherein
the temperature-dependent change (ΔA_{1T}) of the first emission characteristic (A1) is in the opposite direction to the temperature-dependent change (ΔA_{2T}) of the second emission characteristic (A2) or proceeds synchronously therewith.

6. LED lighting device according to any of the preceding claims, wherein
the first LED chip (1) emits mint-coloured radiation and the second LED chips (2) emit amber-coloured radiation.

7. LED lighting device according to any of the preceding claims, wherein
a plurality of n first LED chips (1), which are connected in parallel among one another, are interconnected in series with a plurality of m second LED chips (2), which are also connected in parallel among one another, wherein n is less than m and n and m respectively denote the number of the respective LED chips (1, 2), wherein a current intensity through the second LED chips (2) is less than the current intensity through the first LED chips (1).

8. LED lighting device according to any of the preceding claims,
the mixed radiation (Ag) emits in the white spectral range.

9. Method for producing at least one LED lighting device (10) comprising a first LED chip (1) and a plurality of second LED chips (2), comprising the following method steps:
- producing a plurality of first LED chips (1) suitable for emitting in each case radiation having a first emission characteristic (A1),
- producing a multiplicity of second LED chips (2) suitable for emitting in each case radiation having a second emission characteristic (A2),
- measuring temperature-dependent changes (ΔA_{1T}) of the first emission characteristics (A1) of the first LED chips (1),
- measuring temperature-dependent changes (ΔA_{2T}) of the second emission characteristics (A2) of the second LED chips (2), and
- combining the LED chips (1, 2) to form groups comprising in each case at least one first LED chip (1) and the plurality of second LED chips (2) in such a way that the temperature-dependent change (ΔA_{1T}) of the first emission characteristic (A1) of the first LED chip (1) and the temperature-dependent change (ΔA_{2T}) of the second emission characteristic (A2) of the plurality of second LED chips (2) at least partly compensate for one another or proceed synchronously with one another,
wherein the radiation emitted by the at least one first LED chip (1) is in a wavelength range of between 480 and 520 nm, and the radiation emitted by the second LED chips (2) is in a wavelength range of between 600 and 630 nm,
**characterized in that**
the at least one first LED chip (1) is electrically interconnected in series with the plurality of second LED chips (2), which are electrically connected in parallel among one another.

10. Method according to Claim 9, wherein
the LED lighting device (10) emits identically coloured light (Ag) during operation in a temperature-independent manner.

11. Method according to Claim 9 or 10, wherein
the first LED chip (1) is designed in such a way that it compensates for or synchronizes the temperature-dependent change (ΔA_{2T}) of the second emission characteristic (A2) of the second LED chip (2).

12. Method according to Claim 11, wherein
a lateral distance between n-type contact and p-type contact of the first LED chip (1) is increased for the purpose of compensation.

13. Method according to Claim 11, wherein
the operating current of the first LED chip (1) is increased for the purpose of compensation.

14. Method according to any of the preceding Claims 9 to 13, wherein
a plurality of LED lighting devices (10) are produced in a common method.

15. Method according to Claim 14, comprising the following additional method step:
- equipping a respective LED lighting device (10) with a group of LED chips (1, 2).

## Revendications

1. Dispositif d'éclairage à LED (10) comportant au moins une première puce de LED (1) et une pluralité de secondes puces de LED (2), dans lequel
- la première puce de LED (1) est conçue pour émettre un rayonnement présentant une première caractéristique de rayonnement (A1),
- la seconde puce de LED (2) est conçue pour émettre un rayonnement présentant une seconde caractéristique de rayonnement (A2),
- la première caractéristique de rayonnement (A1) et la seconde caractéristique de rayonnement (A2) présentent des modifications dépendant de la température (ΔA_{1T}, ΔA_{2T}),
- la modification dépendant de la température (ΔA_{1T}) de la première caractéristique de rayonnement (A1) et la modification dépendant de la température (ΔA_{2T}) de la seconde caractéristique de rayonnement (A2) se compensent au moins partiellement lors du fonctionnement ou sont synchronisées l'une par rapport à l'autre de manière à ce que la localisation chromatique d'un rayonnement mixte (Ag) émis par le dispositif d'éclairage à LED (10) soit stable,
- le rayonnement émis par l'au moins une première puce de LED (1) se situe dans le domaine de longueurs d'onde compris entre 480 et 520 nm, et
- le rayonnement émis par la seconde puce de LED (2) se situe dans un domaine de longueurs d'onde compris entre 600 et 630 nm,
**caractérisé en ce que** l'au moins une première puce de LED (1) est connectée électriquement en série avec la pluralité de secondes puces de LED (2) qui sont connectées électriquement en parallèle les unes avec les autres.

2. Dispositif d'éclairage à LED selon la revendication 1, dans lequel le dispositif d'éclairage à LED (10) émet une lumière de même couleur (Ag) lors du fonctionnement indépendamment de la température.

3. Dispositif d'éclairage à LED selon la revendication 1,
dans lequel le dispositif d'éclairage à LED (10) émet un rayonnement mixte (Ag) ayant une localisation chromatique constante.

4. Dispositif d'éclairage à LED selon l'une quelconque des revendications précédentes,
dans lequel la modification (ΔA_{1T}, ΔA_{2T}) des caractéristiques (A1, A2) est un décalage de la longueur d'onde émise et/ou une modification de puissance.

5. Dispositif d'éclairage à LED selon l'une quelconque des revendications précédentes,
dans lequel la modification dépendant de la température (ΔA_{1T}) de la première caractéristique de rayonnement (A1) est opposée à la modification dépendant de la température (ΔA_{2T}) de la seconde caractéristique de rayonnement (A2) ou évolue de manière synchrone par rapport à celle-ci.

6. Dispositif d'éclairage à LED selon l'une quelconque des revendications précédentes,
dans lequel la première puce de LED (1) émet un rayonnement de couleur menthe et la seconde puce de LED (2) émet un rayonnement de couleur ambre.

7. Dispositif d'éclairage à LED selon l'une quelconque des revendications précédentes,
dans lequel une pluralité de n premières puces de LED (1) qui sont connectées en parallèle les unes avec les autres, est connectée en série avec une pluralité de m secondes puces de LED (2) qui sont également connectées en parallèle les unes avec les autres, dans lequel n est inférieur à m et n et m sont respectivement les nombres des puces de LED (1, 2) respectives, dans lequel l'intensité du courant passant à travers les secondes puces de LED (2) est inférieur à l'intensité du courant passant à travers les premières puces de LED (1).

8. Dispositif d'éclairage à LED selon l'une quelconque des revendications précédentes,
dans lequel le rayonnement mixte (Ag) est émis dans un domaine spectral blanc.

9. Procédé de fabrication d'au moins un dispositif d'éclairage à LED (10) comportant une première puce de LED (1) et une pluralité de secondes puces de LED (2), comportant les étapes consistant à :
- fabriquer une pluralité de premières puces de LED (1) qui sont conçues pour émettre respectivement un rayonnement ayant une première caractéristique de rayonnement (A1),
- fabriquer une pluralité de secondes puces de LED (2) qui sont conçues pour émettre respectivement un rayonnement ayant une seconde caractéristique de rayonnement (A2),
- mesurer des modifications dépendant de la température (ΔA_{1T}) des premières caractéristiques de rayonnement (A1) des premières puces de LED (1),
- mesurer des modifications dépendant de la température (ΔA_{2T}) des secondes caractéristiques de rayonnement (A2) des secondes puces de LED (2), et
- combiner les puces de LED (1, 2) en des groupes comportant respectivement au moins une première puce de LED (1) et la pluralité des secondes puces de LED (2) de manière à ce que la modification dépendant de la température (ΔA_{1T}) de la première caractéristique de rayonnement (A1) de la première puce de LED (1) et la seconde modification dépendant de la température (ΔA_{2T}) de la seconde caractéristique de rayonnement (A2) de la pluralité des secondes puces de LED (2) se compensent au moins partiellement ou évoluent de manière synchrone l'une par rapport à l'autre,
dans lequel le rayonnement émis par l'au moins une première puce de LED (1) se situe dans un domaine de longueurs d'onde compris entre 480 et 520 nm et le rayonnement émis par les secondes puces de LED (2) se situe dans un domaine de longueurs d'onde compris entre 600 et 630 nm,
**caractérisé en ce que** l'au moins une première puce de LED (1) est connectée électriquement en série avec la pluralité de secondes puces de LED (2) qui sont connectées électriquement en parallèle les unes avec les autres.

10. Procédé selon la revendication 9,
dans lequel le dispositif d'éclairage à LED (10) émet une lumière (Ag) de même couleur lors du fonctionnement indépendamment de la température.

11. Procédé selon la revendication 9 ou 10,
dans lequel la première puce de LED (1) est réalisée de manière à ce qu'elle compense ou synchronise la modification dépendant de la température (ΔA_{2T}) de la seconde caractéristique de rayonnement (A2) de la seconde puce de LED (2).

12. Procédé selon la revendication 11,
dans lequel un espacement latéral entre un contact n et un contact p de la première puce de LED (1) est augmenté à des fins de compensation.

13. Procédé selon la revendication 11,
dans lequel la compensation du courant de fonctionnement de la première puce de LED (1) est augmentée.

14. Procédé selon l'une quelconque des revendications 9 à 13,
dans lequel une pluralité de dispositifs d'éclairage à LED (10) sont fabriqués par un procédé commun.

15. Procédé selon la revendication 14,
comportant l'étape supplémentaire consistant à :
- doter respectivement un dispositif d'éclairage à LED (10) d'un groupe de puces de LED (1, 2).
